# EUROPEAN PATENT SPECIFICATION

(11) **EP 1 359 755 B1**
(45) Date of publication and mention of the grant of the patent: **09.11.2005**
(21) Application number: 03101752.8
(22) Date of filing: 03.03.1997
(51) Int. Cl.: H04N 7/00

(54) **A coded information signal**
Kodiertes Informationssignal
Signal d'information codé

(30) Priority: 20.12.1996 EP 96203651
(43) Date of publication of application: 05.11.2003
(62) Divisional of application: 97904546.5
(73) Proprietor: Koninklijke Philips Electronics N.V., 5621 BA Eindhoven (NL)
(72) Inventor: VAN DER VLEUTEN, Renatus, J., Prof.Holstlaan 6 5656 AA Eindhoven (NL); BRUEKERS, Alphons, A., M., L., Prof. Holstlaan 6 5656 AA Eindhoven (NL)
(74) Representative: Groenendaal, Antonius W. M.

(56) References cited:
- US-A- 5 021 782
- US-A- 5 045 852
- US-A- 5 488 616

## Description

The invention relates to a method of encoding information signal blocks, the information signal being sampled and quantized so as to obtain representation symbols, which are subsequently coded into code words of different code word lengths, the probability of occurrence for each representation symbol being determined and code words of a small length being assigned to the representation symbols having a high probability of occurrence and code words of greater length being assigned to representation symbols having a low probability of occurrence in accordance with a predetermined coding technique, information about the length of the code words associated with each representation symbol being generated.

The invention also relates to a device for forming coded information signal blocks, comprising means for sampling and quantizing an information signal block so as to obtain representation symbols, means for determining the probability of occurrence of each representation symbol and means for forming codes having a variable length for the different representation symbols, which codes are combined into a representation symbol block.

In such a method an information signal is sampled and quantized in order to obtain representation symbols, which representation symbols, if necessary after further processing, are subsequently coded into code words having different code word lengths.

US-A-5,488,616 discloses a method and a device of the above-mentioned type for variable length coding, wherein information about the length of the code words is generated.

In accordance with the JPEG standard, as described in, for example, the book "JPEG Still Image Compression Standard" by William P. Pennebaker and Joan C. Mitchell, it is known to use codes referred to as Huffman codes for the coding of sampled quantized signals. A Huffman code can be specified completely by defining the number of code words of any possible code word length. The JPEG standard utilizes either fixed Huffman tables, in which a fixed symbol is assigned to each code, or adaptive Huffman tables, in which a code table is determined on the basis of the frequency of occurrence of symbols. In accordance with the JPEG standard a representation symbol is also transmitted for each code word in the case of adaptive tables. A Huffman coding is based on the idea that an efficient coding with code words of different lengths is possible if the shortest code word length is assigned to those code words which occur most frequently.

According to the JPEG standard the code words have a length which varies from 1 to 16 and a representation symbol is assigned to each code word, which representation symbols range from 0 to 255.

The coding in accordance with the JPEG standard is not efficient enough for certain uses, which is particularly so when it is required to transmit a comparatively large number of adaptive Huffman tables for a comparatively small amount of data.

Therefore, it is an object of the invention to provide a signal and a receiver enabling the data relating to the Huffman table specification to be transmitted more efficiently than possible with the Huffman codes as defined in the JPEG standard, and also with the coding technique as described in US-A-5,488,616.

The invention in particular, but not exclusively, is useful to provide an efficient adaptive Huffman coding in the case that the adaptation frequency of the Huffman tables is high, i.e. the tables are adapted a large number of times per unit of time, and at the same time the number of representation symbols in the information signal to be transmitted comprises all or nearly all permissible representation symbols, as can be the case in, for example, audio and video signals.

The method of the invention is characterized in that a coded information signal block is generated which is constituted by information about the length of the code word associated with each possible representation symbol, the information about the length of each of the code words being given a number of bits that is identical to the number of bits that is necessary to encode the length of the code word with the maximum length.

The device according to the invention is characterized by means for generating a coded information block which includes information about the length of the code word associated with each representation symbol, said information having a number of bits that is identical to the number of bits that is necessary to encode the length of the code word with the maximum length.

In accordance with the invention only the length of the associated Huffman code is transmitted for each possible representation symbol. The actual Huffman code words can be derived from this information in an unambiguous manner, as will be explained hereinafter. This requires in the first place that both in the encoder and in the decoder a similar list of symbols is available and the Huffman code word lengths are transmitted in the sequence of this list, while in the second place the Huffman code words derived from the code word lengths are assigned to the symbols in a pre-defined manner. The invention is not based on any assumptions with respect to the probability of occurrence of symbols in the signal to be transmitted.

For an efficient transmission, only the plurality of code words of each length of the quantized signal can be transmitted and at the receiving side a given representation symbol n can be assigned to consecutive representation symbols in a decoder. The representation symbols for audio and video signals are distributed typically symmetrically, for example in accordance with a Gaussian distribution, in such a manner that, when it is assumed that the representation symbols are situated symmetrically relative to the symbol value n and decrease substantially monotonically relative to this vale, the representation symbols whose code words have the smallest lengths occur most frequently and those whose code words have the greatest lengths occur least frequently. However, in order to preclude errors owing to the fact that the actual representation symbols are not transmitted, it is necessary that there is a code word for each possible value of a representation symbol. As use is made of the fact that the distribution is symmetrical, it is necessary that in the case of an odd number of representation symbols a sign bit is added to each representation symbol which is ≠ n, to indicate whether a representation symbol is greater or smaller than n. A sign bit is also allocated to the representation symbol n in the case of an even number of representation symbols.

In addition to the code words, information about the code word of the greatest length occurring in the transmitted signal can be transmitted. In accordance with the JPEG standard the number for all code words having a length of 1-16 is specified by means of an 8-bit number, which means that in total this requires a table of 16 x 8 = 128 bits.

Since the greatest code length that occurs will frequently be much smaller than 16, a more efficient coding table can be obtained by merely transmitting the number that occurs and, in addition, the maximum code word length for the code word lengths which actually occur. For example, when the maximum code word length L = 5 and the maximum permissible length is 16, this requires 4 bits in order to accommodate the greatest code word length in an additional data field. Since there are never more than 2^{L} code words having the length L, only L bits are required in order to define the number of code words of the length L. For L = 5, in accordance with the invention, the table consequently consists of 4 + 1 + 2 + 3 + 4 + 5 = 19 bits, which is a distinct improvement as compared with the above-mentioned 128 bits.

An even more efficient coding is obtained by minimizing both the sum of the number of bits necessary for specifying the table and the number of bits necessary for coding the actual data. When the maximum code word length that is assigned decreases less bits are needed to specify the table but more bits are needed to code the data, because the efficiency of the code decreases as the maximum permissible code word length is reduced. By stepwise reducing the permissible code word length and at the same time monitoring the total number of bits necessary for transmitting the information, it is possible to find the optimum code word length for which the total number of bits to be transmitted is minimal.

It is known that in the case that there are few different representation symbols, for example 7 representation symbols, the efficiency of the Huffman coding can be increased in that a plurality of such representation symbols are grouped into a symbol or a vector of greater length. The efficiency of a Huffman code is guaranteed within 1 bit/representation symbol of the entropy of the signal comprising the representation symbols, which means that in the case of a small number of representation symbols the Huffman code is comparatively inefficient. This is solved by said grouping.

When groups of representation symbols are used the above described method wherein only the plurality of code words of each length of the quantized signal is transmitted, cannot be used in order to increase the efficiency, because the classification of the groups on the basis of their likelihood of occurrence depends on the probability of the representation symbols of which a group consists.

This can be solved by transmitting the quantized probabilities of the original representation symbols. The probabilities, which can be determined by determining the number of times that each representation symbols occurs and dividing this number by the total number of representation symbols in the information signal, can be quantized in. for example, 32 levels.

The number of quantized probabilities can be reduced if in the case of an odd number of representation symbols the distribution of the representation symbols is symmetrical, so that p(n + K) = p(n - K), where n = the central representation symbol, use being made of the fact that the sum of the probabilities is 1. Then, only ((N + 1)/2) - 1 probabilities have to be transmitted for N representation symbols. For a symmetrical distribution where N = 3, for example, only p(n) needs to be given, because p(n+1) = p(n-1) and p(n-1) + p(n) + p(n+1) = 1.

In the case of an even number of N representation symbols similar considerations apply and only N/2 - 1 probabilities have to be transmitted.

In accordance with the above principle the probability of the grouped samples is computed on the basis of the transmitted probabilities both in the encoder and in the decoder, by means of the same algorithm. This is effected by multiplying the probabilities of the individual samples by one another. For example, the probability of the group (n,n,n+1) is calculated by p(n,n,n+1) = p(n) · p(n) · p(n+1). Then, a Huffman code is generated for this vector, the coding used by the encoder and the decoder being obviously the same.

In the case that the distribution of the representation symbols is symmetrical only half the number of representation symbols is used for grouping, which considerably reduces the size of the code. For each representation symbol in the group a sign bit is added to the Huffman code word; in the case of an add number of representation symbols no sign bit needs to be assigned to the representation symbol n.

As long as the encoder and the decoder use the same method of generating the Huffman codes any method leading to a Huffman coding can be used. If Huffman codes of the JPEG type are used, it is advantageous that the greatest code word length that occurs can be limited in a simple manner.

If the probabilities of occurrence of each representation symbol are transmitted in the manner described above, it is also possible to use other variable-length coding techniques, such as arithmetic coding, in which case it is not necessary to form groups of representation symbols.

The above described methods of coding an information signal are particularly suitable for use in a digital audio transmission system in which the signal is divided into subbands and in which the subbands or combinations of subbands are coded by means of the techniques described above for the transmission of the coding information. This means that if the number of representation symbols in (a combination of) subbands is small, for example 3, 5 or 7, the probability of occurrence of each of the symbols is transmitted in order to enable the same coding table to be generated in the encoder and the decoder, grouping of representation symbols being possible. If the number of representation symbols in (a combination of) subbands is larger, for example larger than 9, use is made of the exclusive transmission of information about the number of code words of each length, each code word being associated with a representation symbol, if required in combination with information about the longest code word that occurs.

The invention will now be described in more detail with reference to the drawings. In the drawings:
Figure 1 a-d show an example of a Huffman coding in accordance with a first, second and fifth aspect of the invention;
Figure 2 is a block diagram of a transmission system for a digital audio signal using the coding in accordance with the invention;
Figure 3a, b show a diagram of a method of minimizing the number of bits to be transmitted; and
Figure 4 is s flow chart of a method of reducing the number of bits of the code-table information.

The following example is based on a sampled quantized signal represented by 7 representation symbols or sample values 0-6. An encoder determines the probability of occurrence of each of these 7 representation symbols in the signal block to be transmitted, which can be a signal frame or a subframe, and on the basis thereof a code word of variable length is assigned to each of these representation symbols in accordance with the well-known Huffman coding principle, as described inter alia in the afore-mentioned "JPEG Still Image Compression Standard".

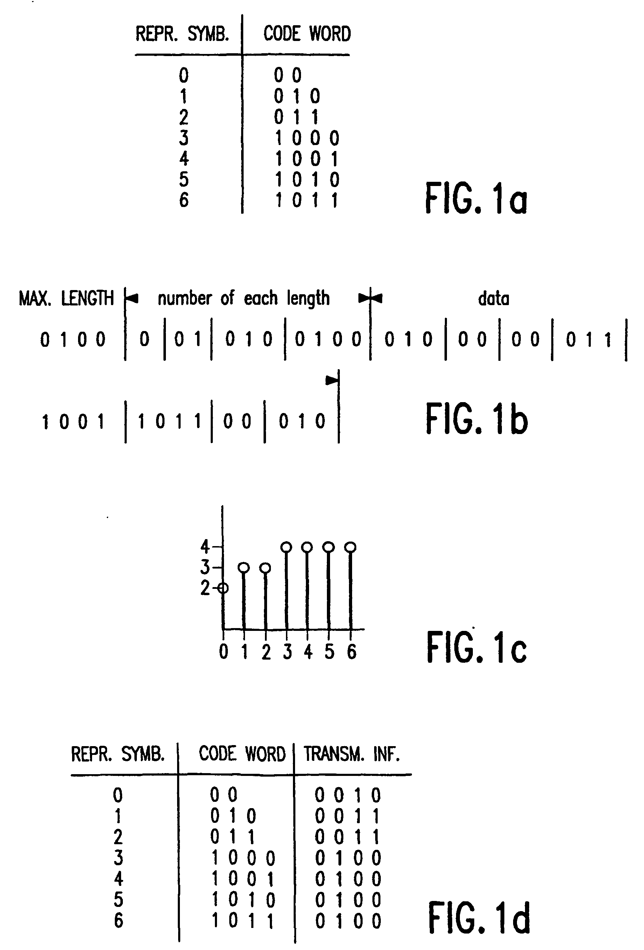

Figure 1a shows the series of representation symbols and the code words assigned thereto by way of example. As is apparent from Figure 1a, there is a code word of a length 2, there are two code words of a length 3 and four code words of a length 4. Information is transmitted via the code word having the greatest length that occurs, in the present case the length 4. In the case of a maximum permissible length 16 this information can be represented by: 0 1 0 0. Subsequently, information about the number of code words of each length is transmitted, a length L requiring a maximum of L bits. In the present example these codes are consequently: 0; 01; 010; 0100. Finally, the codes for the actual representation symbols are transmitted. If the series of representation symbols 1-0-0-2-4-6-0-1 is taken by way of example, the bit series for this symbol series in accordance with Figure 1a is: 010-00-00-011-1001-1011-00-010. The total bit stream transmitted is shown in Figure 1b.

On the basis of this received bit stream the decoder first determines that the maximum code word length is 4 and which representation symbol belongs to which code word. This is possible because the Huffman coding in accordance with JPEG unambiguously defines the code words: code words of a given length (L) for consecutive representation symbols are defined by binary counting and, upon a change to a code word whose length is 1 bit greater (L+1), the existing code word of the length L is first binarily incremented by one and subsequently a 0 is inserted adjacent the least significant bit, after which binary counting proceeds for subsequent code words of the same length. This principle is illustrated in the Table of Figure 1a.

Figure 1c shows diagrammatically how the decoder determines which code word belongs to which representation symbol. Subsequently, the decoder can derive the original series of representation symbols on the basis of the received coded representation symbols, as shown in Figure 1b

Figure 1d shows how for the example of Figure 1a the information about the Huffman code words is transmitted in accordance with the invention. For each possible symbol only the length of the associated Huffman code is transmitted. Figure 1d again shows the same representation symbols in the left-hand column, the Huffman code words of the example in accordance with Figure 1a in the center column, and the transmitted information in the right-hand column. In the case of n possible code words having a maximum lengths of L bits Lxn bits must be transmitted.

For the conventional transmission in accordance with the JPEG standard the number of bits in the case of, for example, 256 symbols is equal to the number of bits required for the information about the number of code words of each length, for example y bits, plus 256 x 8 bits for specifying the symbol associated with each code word. This is (256 x 8) + y bits in total.

With the method in accordance with the invention only 256 x 4 bits are required in the case of Huffman code words having a maximum length of 16, which can be coded by 4 bits (the length 0 does not occur), i.e. less than half the number of bits required in accordance with the JPEG standard.

In the case of the method in accordance with the invention the decoder calculates the histogram of the code word length as a basis for the calculation of the Huffman code word associated with each symbol in accordance with the unique relationship between the Huffman codes and the code word lengths thereof. However, if desired, this histogram can alternatively be calculated in the encoder and the histogram information can be transmitted to the decoder in an efficient manner. This can be effected, for example, in accordance with the standard JPEG method but also by the above described method.

A further efficiency increase can be achieved by using some form of entropy coding to specify the code word lengths, utilizing the information that in general long code words appear more often than short code words. Such entropy coding can be fixed or adaptive.

If all the possible symbols are not used it is also possible to transmit first the information about the symbols actually used to the decoder and subsequently to transmit also the code word length for these representation symbols only.

Finally, besides the transmission of the code word length in accordance with the invention, it is also possible to employ the transmission of Huffman codes wherein an extra bit is used to indicate to the decoder which technique has been selected for the transmission of the Huffman code word information.

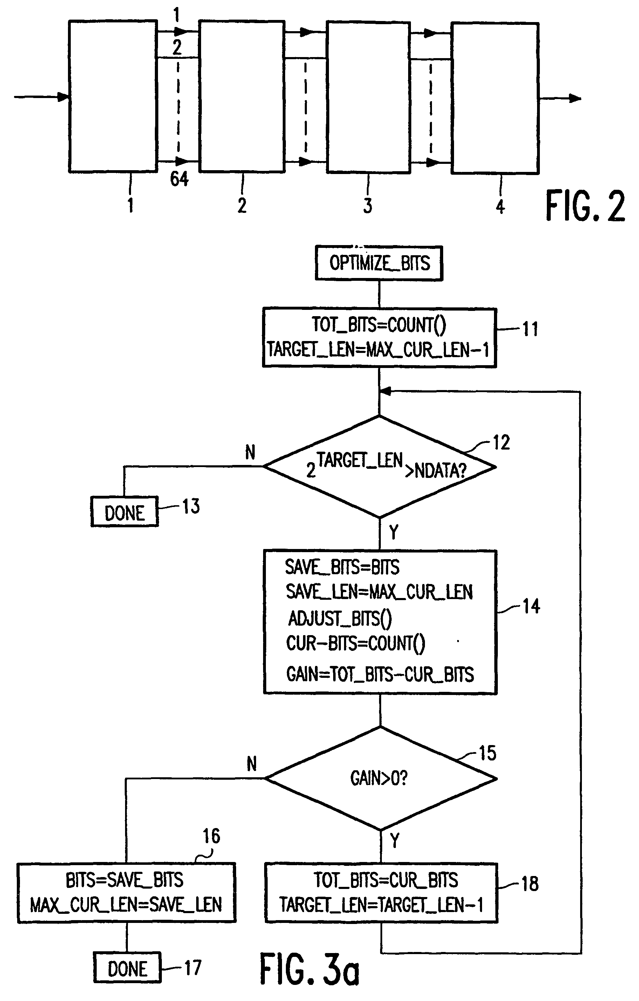

Figure 2 shows diagrammatically a block diagram of a device for transmitting a digital audio signal as a bit stream, the bit stream comprising a minimal number of bits which yet enables the digital audio signal to be reconstructed in a receiver.

In Figure 2 a subband filter bank 1 receives the sampled and quantized digital audio signal and in known manner splits this into, for example, 64 subbands. Each of the subbands is divided into subframes, each comprising for example 24 symbol representations. A number of, for example, 3 subframes forms one frame. In a quantization unit 2 the subframes of each of the subbands are quantized into a given number of representation symbols, for example -2¹⁵ - 2¹⁵ symbols. This quantization is greater than that used for the quantization of the signal applied to the filter bank 1.

A variable-length coding unit 3 combines all subbands of all subframes having an equal number of representation symbols. This is allowed, because it is assumed that the probability density function for all these subbands is the same. For each combination with an equal given number of representation symbols the probability of occurrence of each of the representation symbols is determined. This is effected simply by counting the number of each of the representation symbols and dividing this number by the total number of representation symbols. Since it has been assumed that the distribution of the probabilities of the representation symbols is symmetrical, p(n+K) = p(n-K), where n is the central representation symbol. If the number of representation symbols is small, for example 3, 5 or 7, the probabilities for each representation symbol are transmitted and both the encoder and the decoder define an identical variable-length coding table, for example a Huffman coding table, on the basis of these values. If a Huffman coding is employed, the representation symbols may first be arranged in groups, for example groups of 3 representation symbols, an individual Huffman code being assigned to each group, as set forth hereinbefore. The codes for each group, in the case of Huffman coding, or for each representation symbol are subsequently transmitted and in a receiver the decoder can derive the actual representation symbols from these codes.

The total number of bits necessary for transmitting the (groups) of representation symbols and the information about the probabilities, which information is needed to generate the same (de)coding table in the encoder and the decoder, is constantly checked and compared with the number of bits necessary when for the representation symbols code words of a fixed length are selected. If a fixed-length coding requires a smaller number of bits than the variable-length coding, the first-mentioned coding is used. Such a situation can occur if there are few samples for a given number of representation symbols and the table specification consequently requires a comparatively large number of additional bits.

When the number of representation symbols is greater, for example 9 or more, the variable-length coding unit 4 utilizes a Huffman coding wherein either merely the number of code words of each length is transmitted and/or the code words of the greatest code word length. This technique may be combined with reduction of the greatest code word length and testing whether this results in a reduction of the total number of bits required for transmitting the code table information and the actual codes which the representation symbols represent.

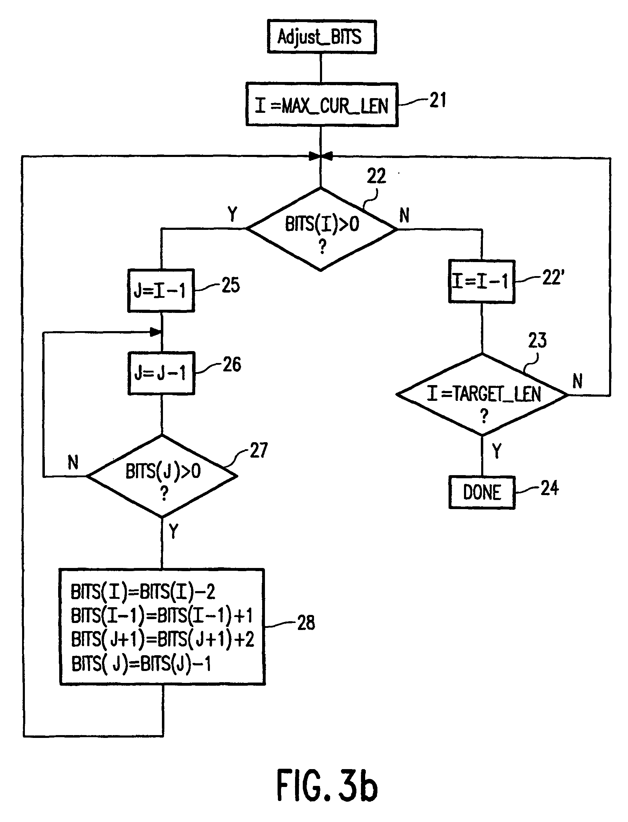

Figure 3a, b is a flow chart showing the steps to be performed in order to realize this.

Input variables for this process are: BITS = the total number of bits required; N DATA = the total number of code words; and MAX-CUR-LEN = the current maximum length of a code word.

In a block 11 the total number of bits is counted and the target code word length (TARGET-LEN) is equalized to MAX-CUR-LEN - 1. In a decision block 12 it is ascertained whether 2^{TARGET-LEN} > N DATA. If this is not the case, a further code word length reduction is not possible and the process is terminated in a block 13. If said requirement is met, the length of the code words having the greatest number of bits is reduced by one in a block 14 by means of a sub-process adjust-BITS, illustrated in Figure 3b.

The adjust-BITS process is a variant of the process used in the JPEG standard in order to ensure that there is no code of a length greater than a predetermined length. This process is described in Appendix A of ISO-DIS 10918-1.

In a block 21 the MAX-CUR-LEN is set to I. In a decision block 22 it is ascertained whether there are I-bit code words; if this is not the case, I becomes I=I-1 in the block 22, and it is decided whether I = TARGET-LEN in a block 23, if yes, the adjust-BITS process is terminated in the block 23 and, if no, the program returns to the block 22.

If there are code words of I bits, this yields J = I-1 in a block 25 and J = J-1 in a block 26. In a decision block 27 it is determined whether there are J-bit code words. If there are no such code words, the program returns to the block 26, and if there are such code words the changes indicated in a block 28 are carried out. As a result of this, the code words of the greatest length (I), which always appear in pairs, are removed in pairs and replaced by two shorter code words. After this has been completed, the loop is traversed again until I = TARGET-LEN.

Furthermore, in the block 14 the GAIN is determined, i.e. the number of bits prior to code word reduction is reduced to the number of bits after this reduction, i.e. TOT-BITS - CUR-BITS. If in a block 15 it appears that GAIN ≤ 0, the process is terminated in blocks 16, 17 and, if this is not the case, the loop is traversed gain via a block 18.

Also in this case, regardless of the techniques used for transmitting the coding information, it is ascertained whether it is perhaps more efficient to use a coding with fixed-length code words and, if this is the case, no Huffman coding is used.

When a Huffman coding is selected it can also be attempted to reduce the total number of bits required for the code table information by combining Huffman codes for different numbers of representation symbols. It is possible, for example, to code 3 representation symbols with a table for 5 representation symbols, which may less efficient but which enables only one instead of two coding information tables to be transmitted.

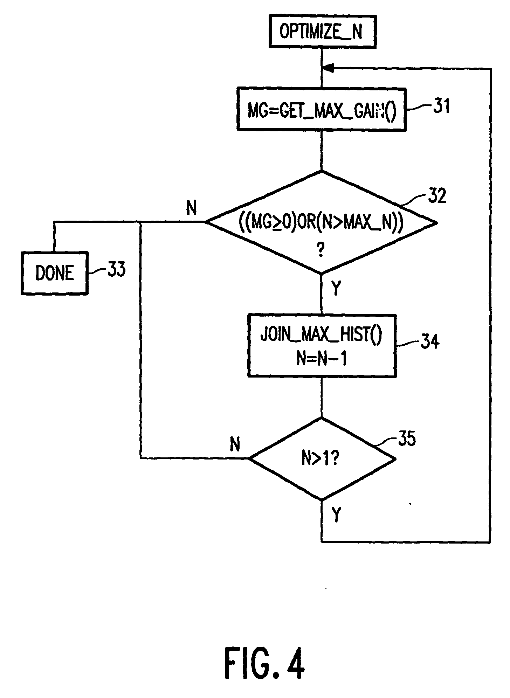

Figure 4 is a flow chart for a process OPTIMIZE-N, which is suitable for this purpose.

Input variables for this process are the level histogram for each Huffman code; N = the total number of Huffman codes, and MAX-N = the predetermined maximum permissible number of codes.

In a block 31 MG is equalized to GET-MAX-GAIN. In the GET-MAX-GAIN subroutine the gain is determined which is obtained by the combination of Huffman codes for a number of levels and the next higher level, the combination yielding the highest gain in bits being selected. In a decision block 32 it is determined whether MG ≥ 0 or whether N > MAX-N. If one of the two conditions is not met, the process is stopped in a block 33. The comparison N > MAX-N? is effected because as long as N > MAX-N the process is also allowed to proceed if MG ≤ 0. If MG ≥ 0 or N > MAX-N, the combination of histograms selected in a block 34 is effectuated and N = N-1. If in a block 35 it is found that N ≤, the process is terminated in the block 33, whereas if N > 1 the loop is traversed again.

The invention is particularly suitable for frame-based coding of representation symbol sources, as occurring in audio and video coding systems, for example symbol sources, without memory and with similar probability density functions.

## Claims

1. A coded information signal representing an information signal being sampled and quantized into representation symbols, the representation symbols being coded into code words of different code word lengths, code words of a small length being assigned to the representation symbols having a high probability of occurrence and code words of greater length being assigned to representation symbols having a low probability of occurrence in accordance with a predetermined coding technique, **characterized in that** the coded information signal includes information about the length of the code word associated with each possible representation symbol, the information about the length of each of the code words being given a number of bits that is identical to the number of bits that is necessary to encode the length of the code word with the maximum length.

2. A signal as claimed in claim 1, wherein the representation symbols are coded by means of a Huffman coding technique.

3. A signal as claimed in claim 1 or 2, **characterized in that** an entropy coding is used for specifying the code word lengths.

## Patentansprüche

1. Codiertes Informationssignal, das ein Informationssignal darstellt, das zu Repräsentationssymbolen abgetastet und quantisiert wird, die daraufhin in Codeworte verschiedener Codewortlängen codiert werden, wobei Codeworte einer geringen Länge den Repräsentationssymbolen zugeordnet werden, die eine hohe Wahrscheinlichkeit des Auftritts haben und Codeworte einer größeren Länge Repräsentationssymbolen zugeordnet werden, deren Auftrittswahrscheinlichkeit gering ist, und zwar entsprechend einer vorbestimmten Codierungstechnik, **dadurch gekennzeichnet, dass** das codierte Informationssignal Information über die Länge des mit jedem möglichen Repräsentationssymbol assoziierten Codewortes aufweist, wobei die Information über die Länge jedes der Codeworte durch eine Anzahl Bit gegeben wird, die der Anzahl Bits entspricht, die notwendig sind zum Codieren der Länge des Codewortes mit der maximalen Länge.

2. Signal nach Anspruch 1, wobei die Repräsentationssymbole mit Hilfe einer Huffman-Codierungstechnik codiert werden.

3. Signal nach Anspruch 1 oder 2, **dadurch gekennzeichnet, dass** eine Entropie-Codierung angewandt wird zum Spezifizieren der Codewortlängen.

## Revendications

1. Signal porteur d'informations codé, représentant un signal porteur d'informations échantillonné et quantifié en symboles de représentation, les symboles de représentation étant codés en mots de code de longueurs de mots de code différentes, les mots de code d'une petite longueur étant attribués à des symboles de représentation ayant une haute probabilité d'occurrence et les mots de code d'une longueur plus grande étant attribués à des symboles de représentation ayant une faible probabilité d'occurrence suivant une technique prédéterminée de codage, **caractérisé en ce que** le signal porteur d'informations codé comprend des informations sur la longueur du mot de code associé à chaque symbole de représentation possible, les informations sur la longueur de chacun des mots de code recevant un nombre de bits identique au nombre de bits nécessaire pour coder la longueur du mot de code ayant la longueur maximale.

2. Signal selon la revendication 1, dans lequel les symboles de représentation sont codés au moyen d'une technique de codage de Huffman.

3. Signal selon la revendication 1 ou 2, **caractérisé en ce qu'**un codage entropique est utilisé pour spécifier les longueurs des mots de code.
